Europäisches Patentamt

European Patent Office

Office européen des brevets

(19)

(11) Veröffentlichungsnummer: **0 001 555**
**B1**

(12) **EUROPÄISCHE PATENTSCHRIFT**

(21) Anmeldenummer: **78100924.6**

(22) Anmeldetag: **18.09.78**

(51) Int. Cl.³: **H 05 K 13/06,**
**H 01 R 23/00, H 02 B 1/20**

(54) Gehäuse mit einem Flachkabel als Kabelbaum zur internen Verdrahtung

(30) Priorität: **28.09.77 DE 2743648**

(43) Veröffentlichungstag der Anmeldung:
**02.05.79 Patentblatt 79/09**

(45) Bekanntmachung des Hinweises auf die Patenterteilung:
**29.10.80 Patentblatt 80/22**

(84) Benannte Vertragsstaaten:
**BE DE FR GB NL**

(56) Entgegenhaltungen:
**DE - A - 2 361 129**
**DE - B - 2 214 503**
**GB - A - 1 302 974**
**US - A - 3 325 769**
**US - A - 3 435 403**

(73) Patentinhaber: **SIEMENS AKTIENGESELLSCHAFT**
**Berlin und München**
**Postfach 22 02 61**
**D - 8000 München 22 (DE)**

(72) Erfinder: **Oliv, Wilhelm**
**Traubingerstrasse 40**
**D - 8133 Feldafing (DE)**

Courier Press, Leamington Spa, England.

## Gehäuse mit einem Flachkabel als Kabelbaum zur internen Verdrahtung

Die Erfindung bezieht sich auf ein mit gedruckten Schaltungsplatten bestücktes Gehäuse der elektrischen Nachrichtenübertragungstechnik, das an einem oberen oder unteren Ende mit einem Anschlußfeld versehen ist, das aus Steckkontaktleisten besteht, und bei dem die gedruckten Schaltungsplatten in auf der inneren Rückseite des Gehäuses angeordnete weitere Steckkontaktleisten einsteckbar sind und zur Verdrahtung der weiteren Steckkontaktleisten mit den Steckkontaktleisten des Anschlußfeldes ein Band- bzw. Folienkabel verwendet ist.

Während bei den älteren Nachrichtenübertragungseinrichtungen die elektrischen Baugruppen in Horizontaleinschüben untereinander in Gestellen angeordnet waren, wird bei den modernen Konstruktionen die sogenannte Vertikalbauweise verwendet. Diese besteht im wesentlichen darin, daß der jeweilige Einschub zur Geräteaufnahme aus einem einfachen Blechgehäuse besteht. Am oberen Ende dieser Gehäuse ist auf der Vorderseite ein Schaltfeld, auf der Rückseite ein Steckanschlußfeld für die Amtskabelverdrahtung angebracht. In einknüpfbare Führungsschienen an beiden Seitenwänden lassen sich Plattenbaugruppen mit gedruckten Schaltungsplatten einschieben. Hierbei ist sichergestellt, daß die auf den Plattenbaugruppen angebrachten Stiftsteckverbinder zwangsläufig in die Gegenstücke im Einsatz eingreifen. Einzelne Verschlüsse verbinden die Baugruppen kraftschlüssig mit dem Gehäuse. Auf der Rückseite des Gehäuses liegt ein mit einer Blende abgedeckter Verkabelungsraum. Derartige Vertikaleinheiten werden in Aufnahmevorrichtungen eingeführt, die entweder wie beim bisherigen Gestellcharakter haben oder anstelle des bisherigen Gestells lediglich sogenannte senkrechte Gestellspalten, die als Metallstützen mit konsolartigen Aufnahmevorrichtungen für die vertikalen Geräteeinsätze dienen. Beim Einschieben der Gehäuse greifen die auf ihrer Rückseite angebrachten Steckverbinder in die schwimmend angeordneten Gegenstücke der Aufnahmevorrichtung ein, an die die Amtsverdrahtung angeschlossen ist.

Die Verkabelung im rückseitig angeordneten Verkabelungsraum zwischen den einzelnen Steckbaugruppen im Gehäuse untereinander sowie dem Schalt- und Anschlußfeld wird dabei in der herkömmlichen Verdrahtungstechnik mit in Kabelbäumen zusammengefaßten Schaltdrähten durchgeführt, wodurch ein gewisser Verdrahtungsraum benötigt wird. Bei der DE—B—22 14 503 liegt eine derartige Einrichtung vor, bei der diese Verkabelung über ein oder mehrere S-förmig gebogene Band- oder Folienkabel durchgeführt ist.

Der Erfindung liegt die Aufgabe zugrunde, eine vereinfachte Ausführung für ein derartiges Band- bzw. Folienkabel für die eingangs genannte Einrichtung zu schaffen, die es gestattet, in einem einzigen Arbeitsgang durch Schwall- oder Tauchlöten die Verbindungen zwischen den Steckelementen und dem Folienkabel herzustellen.

Diese Aufgabe wird bei einer Einrichtung der eingangs genannten Art gemäß der Erfindung dadurch gelöst, daß das Folienkabel in der Draufsicht auf die Kaschierung im ungefalteten Zustand gabelförmig ausgebildet ist, mit einer langen Mittelzinke und wenigstens zwei gegeneinander abgestuften kürzeren seitlichen Zinken, und daß die lägste seitliche Zinke über die Mittelzinke gefaltet ist und darüber die kürzeren, daß ferner die mittlere Zinke am oberen Ende umgebogen und dort wie die anderen Zinken auf der gleichen Kaschierungsseite mit den Steckkontaktleisten des Anschlußfeldes verlötet ist.

Dies bringt gegenüber den bisherigen Ausführungen die Vorteile mit sich, daß das Bandkabel aus einem Element besteht, das in einem einzigen Arbeitsgang mit den Steckelementen an den Enden der Gabelabschnitte durch Schwall- oder Tauchlöten verbunden werden kann. Ferner lassen sich zusätzliche Verdrahtungen an diesen Steckelementen, beispielsweise durch feste gedruckte Schaltungsplatten vermeiden. Durch die besondere Art des Zuschnitts und der Faltung werden entgegengerichtete Steckrichtungen an der Wurzel und an den Enden der Gabelabschnitte erreicht.

Nachstehend wird die Erfindung anhand dreier Figuren näher erläutert.

Die Fig. 1 zeigt ein Steckeinschubgehäuse der Vertikalbauweise, das zur Sichtbarmachung der Folienverdrahtung aufgeschnitten dargestellt ist,

die Fig. 2 zeigt die Ausführung der Folienverdrahtung im ungefalteten Zustand mit angelöteten Steckbauelementen,

die Fig. 3 zeigt ein perspektivische Darstellung des Folienkabels samt Steckelmenten im Einbauzustand.

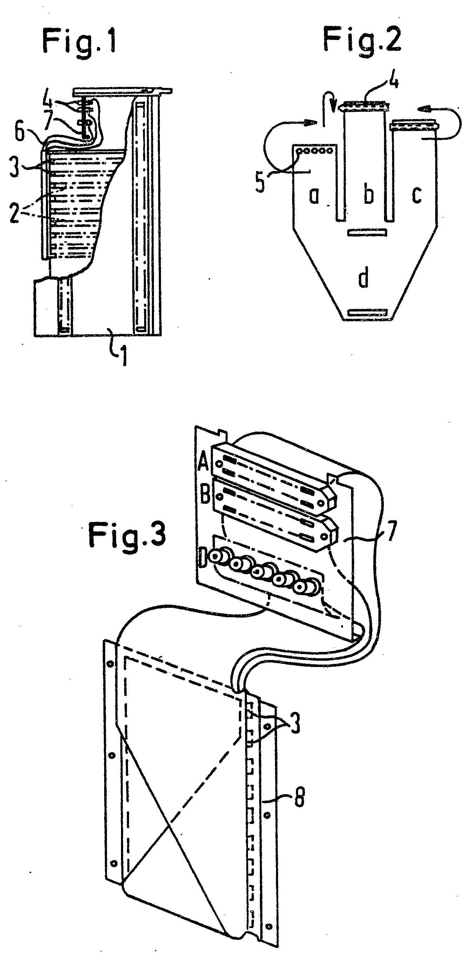

In der Fig. 1 ist ein Gehäuse der sogenannten Vertikalbauweise oder auch Bauweise 7R genannt dargestellt. Dieses Gehäuse 1 ist mit Steckbaugruppen 2 gefüllt, zu dessen Aufnahme es entsprechende Führungsleisten und rückseitige Steckbuchsenleisten 3 trägt. An einem Ende dieses als Einschub ausgebildeten Gehäuses, das in eine entsprechende gestellartige Aufnahmevorrichtung eingeschoben werden kann, ist ein Anschlußfeld vorgesehen. Dieses Anschlußfeld ist in der Darstellung der Fig. 1 oben vorgesehen und trägt Steckelemente 4 und 5. Es kann jedoch auch seitlich oder unten vorgesehen werden oder es können mehrere Anschlußfelder vorgesehen sein. Diese Steckelemente sind hier als Messerleisten 4 ausgebildet und als Koaxialstecker, die mit 5 bezeichnet sind. Die Verbindungen zwischen diesen oberen 4, 5 und unteren Steckelementen 3 ist nun laut Vorschlag mit einem einzigen Bandkabel bzw. Folienkabel 6 durchgeführt. Wenn das Kabel gemäß Fig. 2 ausgebildet ist, wird die Umkehr der Steckrichtung einfach möglich. Wie die Fig. 2 zeigt, ist das Band-Folienkabel gabelförmig ausgebildet mit drei Gabelzinken a, b und c und der Wurzel d. Wenn nun die Gabelzinken dieses Folienkabels in der durch Pfeile angedeuteten Richtung übereinander gefaltet bzw. umgeschlagen sind, so läßt sich, wie aus den Fig. 1 und 3 besser ersichtlich, eine Umkehr der Steckrichtungen erzielen. Dieses läßt sich dadurch erreichen, daß die drei gabelförmigen Abschnitte (Gabelzinken) unterschiedlich lang gemacht werden, wobei der mittlere Abschnitt der längste ist. Dieser Mittel-abschnitt b wird im Einbauzustand am oberen Ende umgebogen und trägt dort die Messerkontaktleiste A. Der etwas kürzere Gabelabschnitt c wird dann über den die Wurzel bildenden Abschnitt d gefaltet, wie alle Abschnitte S-förmig gebogen un trägt am Ende die Messerleiste B. Das gleiche wird auch mit dem noch kürzeren Gabelabschnitt a vorgenommen, d.h. er wird über den ersteren Gabelabschnitt c gefaltet, S-förmig gebogen und trägt am oberen Ende die Steckkontaktleiste D. In diesem Spezialfall sind die unteren Steckkontakte D als Koaxialstecker ausgebildet, so daß sich für diese Stecker die kürzesten Verbindungen, die auf der Folie als flächige Koaxialkabel ausgeführt sind, ergeben. Für den Einbau ist es ferner vorteilhaft, zwischen die gefalteten Abschnitte Isolierstreifen z.B. aus Schaumstoff einzulegen.

Wei bei der Fig. 3 dargestellt, werden die Kontaktleisten am oberen und unteren Ende der Gabel vorteilhaft auf Blechen 7 bzw. 8 mechanisch verbunden.

Das Folienkabel kann so in einem einzigen Arbeitsgang in gestreckter Form gemäß Fig. 2 durch Schwall- oder Tauchlötung mit sämtlichen Steckanschlußleisten verbunden werden. Eine Doppelkaschierung wäre also hierzu nicht erforderlich, ebenso wenig wie eine Umkehr der Verdrahtung auf der Kaschierung. Vorteilhaft werden jedoch beidseitig kaschierte Folien verwendet, wobei über die Stifte der Steckelement beim Verlöten die Durchkontaktierung erfolgt. Es können ferner auch Bauteile gleichzeitig mitverlötet werden.

Die Gestalt der Folie kann ferner auch mehr als dreizinkig sein, z.B. fünfzinkig bei entsprechender Übereinanderfaltung der Abschnitte. Vorteilhaft läßt sich die Gabel auch auf der der Wurzel gegenüberliegenden Seite, z.B. symmetrisch erweitern, wenn es wegen beidseitiger Anbringung von Anschlußfeldern nötig ist.

### Patentansprüche

1. Mit gedruckten Schaltungsplatten (2) bestücktes Gehäuse (1) der elektrischen Nachrichtenübertragungstechnik, das an einem oberen oder unteren Ende mit einem Anschlußfeld versehen ist, das aus Steckkontaktleisten (4, 5) besteht und bei dem die gedruckten Schaltungsplatten (2) in auf der inneren Rückseite des Gehäuses (1) angeordnete weitere Steckkontaktleisten (3) einsteckbar sind und zur Verdrahtung der weiteren Steckkontaktleisten (3) mit den Steckkontaktleisten (4, 5) des Anschlußfeldes ein Band- bzw. Folienkabel (6) verwendet ist, dadurch gekennzeichnet, daß das Folienkabel (6) in der Draufsicht auf die Kaschierung im ungefalteten Zustand gabelförmig ausgebildet ist, mit einer langen Mittelzinke (b) und wenigstens zwei gegeneinander abgestuften kürzeren seitlichen Zinken (a, c) und daß die längste seitliche Zinke (c) über die Mittelzinke (b) gefaltet ist und darüber die kürzeren (a), daß ferner die mittlere Zinke (b) am oberen Ende umgebogen und dort wie die anderen Zinken auf der gleichen Kaschierungsseite mit den Steckkontaktleisten (4, 5) des Anschlußfeldes verlötet ist.

2. Gehäuse nach Anspruch 1, dadurch gekennzeichnet, daß die Enden der Gabelzinken des Folienkabels mit Messerkontaktleisten (4) und/oder Koaxialsteckern (5) verlötet sind und die Wurzel (d) der Gabel mit den weiteren Steckkontaktleisten (3), die Gegenstücke für Steckbaugruppen (2) bilden.

3. Gehäuse nach Anspruch 1 oder 2, dadurch gekennzeichnet, daß die Verlötung der Steckkontaktleisten (3, 4, 5) mit dem Band oder Folienkabel (6) in einem Arbeitsgang durch Tauch- oder Schwallötung vorgenommen ist.

4. Gehäuse nach einem der vorhergehenden Ansprüche, dadurch gekennzeichnet, daß die Gabel auf der Gegenseite zu den oberen Gabelzinken (a, b, c), zum Beispiel symmetrisch erweitert, ebenfalls mit Zinken versehen ist.

### Revendications

1. Boîter (1) de la technique électrique des transmissions d'informations, qui est équipé de plaquettes à circuits imprimés (2) et est muni à son extrémité supérieure ou à son extrémité inférieure d'un panneau de raccordement qui est constitué par des barrettes de contact à enfichage (4, 5), et dans lequel les plaquettes à circuits imprimés (2) peuvent être enfichées dans d'autres barrettes de contact à enfichage (3) disposées sur la face arrière intérieure du boîtier (1) et dans lequel un câble en forme de bande ou de feuille (6) est utilié pour réaliser le câblage entre lesdites autres barrettes de contact à enfichage (3) et les barrettes de contact à enfichage (4, 5) du panneau de raccordement, caractérisé par le fait que le câble en forme de feuille (6) est réalisé avec une forme de fourche à l'état non replié, suivant une vue de dessus sur le revêtement, avec une dent médiane plus longue (b) de la fourche et au moins deux dents latérales (a, c) plus courtes et étagées l'une par rapport à l'autre, que la dent latérale (c) la plus longue est repliée par dessus la dent médiane (b) et que les dents les plus courtes (a) sont repliées par dessus la dent médiane, qu'en outre la dent médiane (b) est recourbée à son extrémité supérieure et est soudée à cet endroit, comme les autres dents, sur la même face du revêtement aux barrettes de contact à enfichage (4, 5) du panneau de raccordement.

2. Boîtier suivant la revendication 1, caractérisé par le fait que les extrémités des dents de la fourche constituée par le câble en forme de feuille sont soudées à des barrettes de contact à couteaux (4) et/ou à des connecteurs coaxiaux (5) et le pied (d) de la fourche forme, avec lesdites autres barrettes de contact à enfichage (3), les pièces antagonistes pour des modules enfichables (2).

3. Boîtier suivant une des revendications 1 ou 2, caractérisé par le fait que le soudage des barrettes de contact à enfichage (3, 4, 5) au câble en forme de bande ou de feuille (6) est effectué suivant une phase opératoire par soudage par immersion ou par soudage à la vague.

4. Boîtier suivant l'une des revendications précédentes, caractérisé par le fait que sur le côté opposé aux dents supérieures de la fourche (a, b, c), ladite fourche s'étend par exemple de façon symétrique et est également munie de dents.

**Claims**

1. Housing (1) which relates to electrical communications transmission technology and is equipped with printed circuit boards (2) and provided at an upper or lower end with a terminal array which consists of plug contact strips (4, 5), and wherein the printed circuit boards (2) can be inserted into further plug contact strips (3) which are arranged on the inner side of the housing (1) and wherein a ribbon- or foil cable (6) is used to wire the further plug contact strips (3) to the plug contact strips (4, 5) of the terminal array, characterised in that, in plan view of the sheathing, the foil cable (6) is forked when unfolded, with a long central lug (b) and at least two shorter lateral lugs (a, c) which are staggered relative to one another, and that the longest lateral lug (c) is folded over the central lug (b) with the shorter ones over this, and that furthermore the central lug (b) is bent at its upper end and is there soldered to the plug contact strips (4, 5) of the terminal array like the other lugs on the same side of the sheathing.

2. Housing as claimed in claim 1, characterised in that the ends of the fork lug of the foil cable are soldered to spade-contact strips (4) and/or coaxial plugs (5) and the root (d) of the fork is soldered to the further plug contact strips (3) which form counterpieces for plug-in modules (2).

3. Housing as claimed in claim 1 or 2, characterised in that the plug contact strips (3, 4, 5) are soldered to the ribbon- or foil-cable (6) by means of dip- or wave-soldering in one operation.

4. Housing as claimed in one of the preceding claims, characterised in that the fork which widens, for example, symmetrically on the opposite side to the upper fork lugs (a, b, c) is likewise provided with lugs.

# Fig.1

# Fig.2

# Fig.3